# EUROPEAN PATENT APPLICATION

(11) **EP 2 453 038 A1**
(43) Date of publication of application: **16.05.2012**
(21) Application number: 10191391.1
(22) Date of filing: 16.11.2010
(51) Int. Cl.: C23C 16/27, D04B 15/14, B81B 3/00

(54) **Method for coating micromechanical parts with dual diamond coating**

(71) Applicant: The Swatch Group Research and Development Ltd., 2074 Marin (CH)
(72) Inventor: Bourban, Stewes, 1588 Cudrefin (CH); Richard, David, 1400 Yverdon-les-Bains (CH); Gilomen, Beat, 2540 Grenchen (CH); Steinmüller, Detlef, 6074 Aldrans (AT); Drexel, Herwig, 6080 Igls (AT); Steinmüller, Doris, 6074 Aldrans (AT); Ghodbane, Slimane, 6020 Innsbruck (AT)
(74) Representative: Ravenel, Thierry Gérard Louis

(57) **Abstract**

Method for coating micromechanical components of a micromechanical system, in particular a watch movement, comprising:
• providing a substrate (4) component to be coated;
• providing said component with a first diamond coating (2) doped with boron ;
• providing said component with a second diamond coating (3); wherein :
• said second diamond coating (3) is provided by CVD in a reaction chamber;
during CVD deposition, during the last portion of the growth process, a controlled increase of the carbon content within the reaction chamber is provided, thereby providing an increase of the sp2/sp3 carbon (6) bonds up to an sp2 content substantially between 1% and 45%. Corresponding micromechanical components are also provided.

## Description

### FIELD OF THE INVENTION

The invention relates to a method for coating micromechanical components of a micromechanical system, in particular a watch movement, in order to provide a reduction of the surface roughness, an enhancement of the tribological performances and reduction of dust accumulation on working surfaces. The invention also relates to the corresponding micromechanical component for a micromechanical system, in particular a watch movement. The invention can be used in micromechanical watch movements, in particular for the realisation of escapement wheels and pallets and other friction-relevant components.

### BACKGROUND TO THE INVENTION

The technical demands on micromechanical components are growing. Beside highest precision, there is a need to provide highest energy efficiency in the mechanical system, long lifetime and complete abdication of lubricants insofar as possible.

In the last few years, a lot of documents dealing with this subject have been published. The described approaches fulfil some of the tasks without being able to deliver a complete solution mainly due to the restrictions on the materials used.

Micromechanical components produced by mechanical machining (die cutting or shape cutting) exhibit two major disadvantages. First, they are either high priced or economically profitable only in mass production because investments are required for expensive production tools. Second, these processes reach their technical limits with an accuracy level lying by +/- 5 micrometers.

Thus several alternative approaches have been discussed in literature. One of the most promising ideas relates to the etching of micromechanical parts from silicon wafers achieving highest precision, even exceeding the results of the machining techniques by far. The tolerances can be reduced to the sub-micrometer range, but at the expense of lifetime: in practical results it was shown that the mechanical strength as well as the abrasive wear of these parts could not meet the demands in the absence of lubricant. One solution to the problem has been demonstrated in EP patent No 1 904 901: by treating the surface of the micromechanical parts with oxygen. The strength and the lifetime could be extended, but without achieving an ultimate solution however.

The energy efficiency could be enhanced by using special oils in mechanical systems, however at the expense of the demand for a dry running system.

The longest lifetime is achieved by classical machined parts made of steel, but these systems have reached their limits in regard to high accuracy and have to be further lubricated.

A further problem of the lubricated systems is the necessity for frequent service intervals, where the movements have to be cleaned and re-lubricated. Thus the cycles of operation are limited and additional costs arise. These service intervals are necessary due to aging of the used oils which loose their properties with time.

Numerous approaches to fulfil all these requirements with one system have been undertaken.

In EP0732635B1 an approach is described where the micromechanical parts are etched from a silicon wafer and then coated with diamond films. The diamond films obtained via this method have a surface roughness higher than 400nm. These films require therefore a subsequent polishing if the diamond coated parts are used in sliding contact applications.

EP1233314 discloses a mechanical clockwork assembly for watches having a mechanical escapement with an escapement wheel and an anchor wherein the functional elements of the escapement wheel are at least partially coated on their operating surfaces with a DLC (diamond like carbon) coating. DLC has a high sp2 content (ranging from 30 - 100%) and is amorphous carbon which hardness is not sufficient for effective wear protection applications.

EP1622826 discloses a micromechanical component comprising a first surface and a second surface, which are substantially perpendicular in relation to one another wherein the first and/or the second surface consist at least partially of diamond.

US 5308661 discloses a process for the pre-treatment of a carbon-coated substrate to provide a uniform high density of nucleation sites thereon for the subsequent deposition of a continuous diamond film without the application of a bias voltage to the substrate.

EP1182274A1 discloses a method for the post-treatment of diamond coatings where a coarse-grained (micrometer regime) diamond coating is deposited on machining tools and subsequently treated be means of plasma processes. The aim of this post-treatment is the degradation of the top layers of the sp3-hybridised diamond coating into sp2-hybridised carbon species. The expectation is a filling of the "surface valleys" between the coarse grains protruding from the surface to achieve a more flat surface. The result of such method is a film having a coarse grain sp3 diamond on top of which is a top layer of several hundred nanometres of sp2 hybridised amorphous carbon. The top layer is relatively soft and will wear off quickly in applications involving high friction.

All the solutions described above can solve only partly the problem of providing micromechanical components featuring coefficient of friction lower than 0.05, and thus a large-scale production was prevented which is however demanded in the watch industry for instance.

In particular, when using diamond-coated silicon, the solutions described above raised the following problems: the diamond coated micromechanical components often exhibit a high coefficient of friction because of the microcrystalline structure of the diamond coatings. This high coefficient of friction severely limits the efficiency of the micromechanical system.

It is well known that surfaces with a roughness above several hundred nanometres cannot achieve low coefficients of friction. Moreover, utilising coarse diamond films in mechanical systems require a very smooth counterpart. In such cases the rough diamond film would grind into its corresponding counterpart leading to a very quick abrasive wear of the system.

In theory, a special case is imaginable, where different roughness's modules are fitting special conditions and therefore produce a low coefficient of friction. However the pressure on the single grains would be too high leading to a breaking and/or interlocking of the grains. The mechanical system would thus lose its properties very quickly ending up in a high coefficient of friction and thus a blocking of the system. After the breakdown of the coating, the whole system will collapse.

Solutions suggesting a polishing after the diamond-coating and therewith a smoothening of the surface of the micromechanical components failed because of high costs, the low efficiency and an essential technical reason: the most important functional surfaces are the flanks of the micromechanical parts which are not accessible for mechanical polishing when mounted in a wafer. A polishing after removing the parts from the wafers is not possible and moreover uneconomic because of the multitude and the diminutiveness of the micromechanical parts. Solutions with plasma etching of a diamond coated wafer comprising the micromechanical parts have also failed due to non-homogeneity of the plasma polishing especially on the flanks of the parts, which are the most important areas (see above).

Approaches using smaller crystal sizes (of a few hundreds nanometres) suffered similar problems in smaller dimensions. For instance, plasma etching of the flanks is not feasible because these processes affects mainly the grain boundaries and etches the surfaces in an anisotropic way.

Additionally, anisotropy of the etching treatment can arise from several parameters. The etching efficiency depends strongly on the crystallographic orientations of the diamond crystals. As diamond films grown on substrates other than diamond (silicon in most cases), they exhibit a mixture of crystallographic orientations, making etching non-uniform, which can even increase the surface roughness of diamond instead of decreasing it.

### SUMMARY OF THE INVENTION

A general aim of the invention is therefore to provide a process that allows providing micromechanical components for a micromechanical system, in particular a watch movement, providing a longest lifetime.

A further aim of the invention is to provide a process allowing providing micromechanical components for a micromechanical system, in particular a watch movement, reducing service intervals.

A further aim of the invention is to provide a process allowing providing micromechanical components for a micromechanical system, in particular a watch movement, reducing friction.

Still another aim of the invention is to provide micromechanical components for a micromechanical system, in particular a watch movement, enhancing tribological performances.

A further aim of the invention is to provide a process allowing providing micromechanical components for a micromechanical system, in particular a watch movement, reducing dust accumulation at the surface of the components.

These aims are achieved thanks to a process for coating micromechanical components of a micromechanical system, in particular a watch movement, and a micromechanical component for a micromechanical system, as defined in the claims.

There is accordingly provided a method for coating micromechanical components of a micromechanical system, in particular a watch movement, comprising:
- providing a substrate component to be coated;
- providing said component with a first diamond coating doped such as to increase the conductivity of the diamond layer;
- providing said component with a second diamond coating;
   wherein :
   - said second diamond coating is provided by deposition in a reaction chamber;
   - during deposition of said second coating, a controlled increase of the carbon content within the reaction chamber is provided, thereby providing an increase of the sp2/sp3 carbon bonds in the substantially outer portion of the coating up to an sp2 content substantially between 1% and 75%.

Such dual coating enables to get the advantages of two complementary technologies. The first coating provides long-term stability due to hardness of diamond and the high adherence between diamond and the silicon substrate. The second coating is highly resistant to wear while providing low friction and substantially high conductivity. The high conductivity reduces dust accumulations at the surface of the coating.

In a preferred embodiment, said sp2 content is substantially between 1 % and 45%, and most preferably between 15% and 30%.

In another embodiment, the first diamond coating is doped with boron, or phosphorus or sulphur or aluminum.

In yet another embodiment, the first and second diamond coatings are provided by CVD in a reaction chamber.

The reaction time for providing the second layer is preferably shorter than the reaction time for providing the first layer.

The thickness of the first layer is preferably between 500 nm and 100 micrometer, and most preferably less than 10 micrometer.

The thickness of the second layer is preferably between 1 and 100 micrometer, and most preferentially less than 10 micrometers.

In a still further embodiment, the micromechanical component is an escapement wheel and wherein during process, the escapement wheel is provided on a refractory wire, so that the rotation axis of the escapement wheel is substantially horizontal.

The increase of carbon content may be obtained by increasing the proportion of carbon containing reactant gas, or by adding an additional carbon containing gas, or by increasing the temperature and/or pressure within the processing reaction chamber, or by adding gaseous nitrogen to the reaction chamber, or by replacing hydrogen by argon, or by adding at least one rare gas.

The invention further provides a micromechanical component for a micromechanical system, in particular a watch movement, obtained by a method as previously described. In an advantageous embodiment, the surface layer has a gradual increase of sp2 hybridized carbon content. In a preferred example, the component is an escapement wheel. In a further example, the component is a pallet.

Such mechanical components, produced for micromechanical systems allow the running of the mechanical system under dry (unlubricated) conditions, feature high tribological performances (very low friction coefficient, reduced wear, etc), are long-time stable and feature high energy efficiency.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings, in which:
- Figure 1 is a schematic representation showing the substrate and the two diamond films after the two process steps in accordance with the invention;
- Figures 2a and 2b are schematic representations of the surface structure of a diamond film deposited according to the method of the invention for different grain sizes, resulting in a low roughness, and therefore a low coefficient of friction, when the grain size is the smallest;
- Figure 3 is an illustration of an example of a local sp2-distribution function,
- Figure 4 and 5 are respectively diagrams of X-Ray Diffraction - and Atomic Force Microscopy measurements of films obtained by the method disclosed in AT399726,

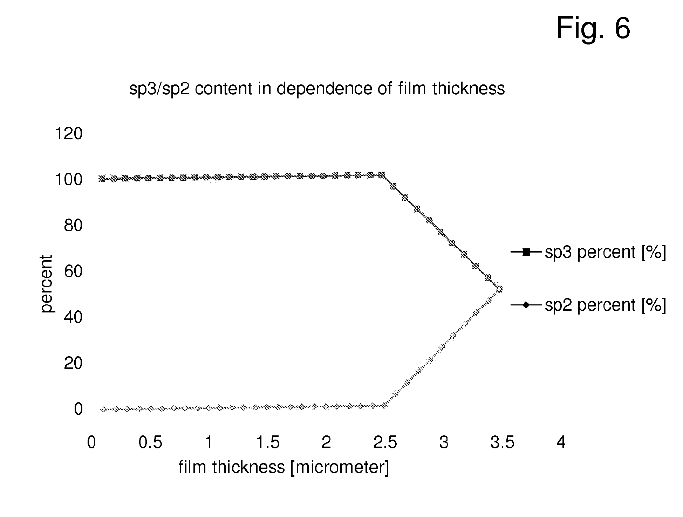

- Figure 6 is a graph showing the evolution of the sp2/sp3 content as a function of thickness of the deposited diamond film.

### DETAILED DESCRIPTION OF THE INVENTION

Once the substrates to be coated have been properly prepared, the coating process, including two main steps, may be started.

In step one, a nanocrystalline diamond layer doped with boron is applied on the substrates. The application time is long enough to allow a diamond layer of several micrometers: that is to say between one hour to about one hundred hours, and most preferably around ten hours.

If escapement wheels and pallets are being coated, during the application phase, the escapement wheels are advantageously provided on a support wire, specially adapted to resist very high temperatures. This enables the rotational axis of the wheels to be in a substantially horizontal position.

More details about the application of the first layer are given further in this document.

Step two of the coating process consists in the application of a nanocrystalline diamond layer, while providing an important supply of carbon and boron, in order to get the most advantageous properties. During this step, the sp2 carbon quantity is gradually increased up to substantially 25 %. This proportion is based on an estimation made during gaseous phase. The application time is long enough to allow growing a diamond layer of several micrometers: that is to say between one hour to about one hundred hours, and most preferably around ten hours. The application time for the second layer may be shorter than the application time of the first layer.

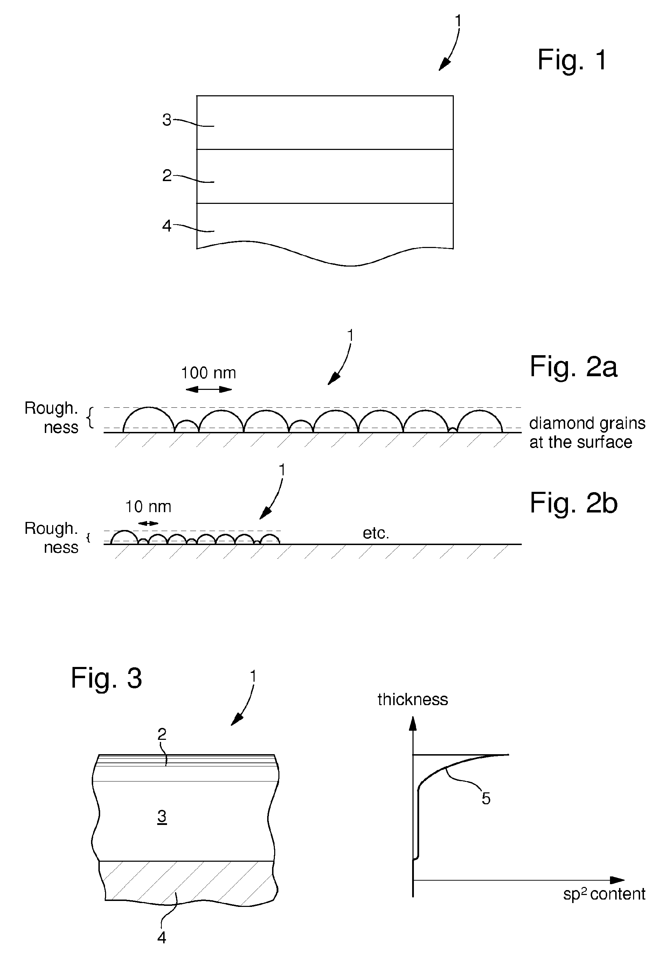

Figure 1 illustrates an example of a coated substrate 4, provided with a first diamond coating 2 and a second diamond coating 3 forming a diamond dual protection layer 1.

According to an example concerning escapement wheels and pallets, the following thicknesses are provided:
- Escapement wheels: 9,8 um on top and 10 um on the sidewalls;
- Silicon square pallets 2X2 cm2: 7,0 um;
- Balls of 6 mm diameter: 8,3 um

The nanocrystalline diamond films are produced by a CVD (chemical vapor deposition) process. In the special CVD process (discloses in AT399726B incorporated herein by reference) a carbon containing gas species (for example methane) is thermally activated and is deposited on a substrate as diamond (sp3-hybridised carbon), as graphite (sp2-hybridised carbon) as well as carbonhydrates or other carbon species (mixtures of sp2- and sp3-hybridised carbon). To obtain a pure diamond layer it is necessary to use a second gas: hydrogen. The hydrogen gas (H2) is also thermally activated resulting in mono-atomic hydrogen, where, as an important process step, the efficiency of the activation process is extremely high (more than 50%), preferably more than 75% and achieving in special cases 90% and more. Such a method is described in AT399726B.

With this process, the nanocrystalline diamond coatings 1 (Figures 2a and 2b) can be deposited on a substrate, such as silicon, with diamond crystal sizes of less than 8 nanometres having a surface roughness of less than 10 nanometres, for instance as shown in Figure 2b.

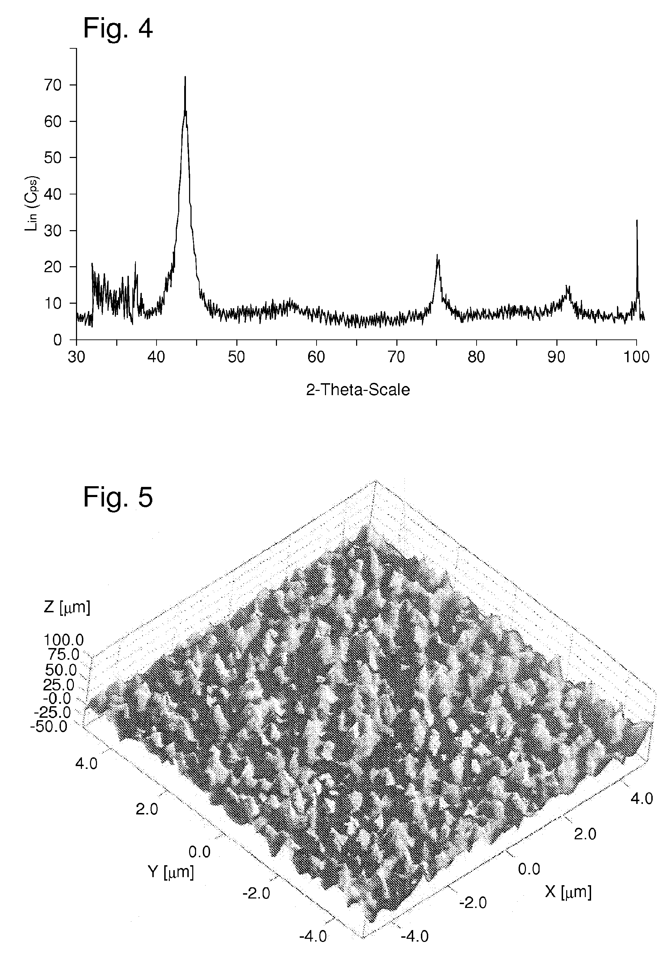

X-Ray Diffraction - and Atomic Force Microscopy analysis of films obtained by the method disclosed in AT399726B is shown in figures 4 and 5.

In step two, during the growth of the diamond film the process is tuned in a way to achieve a gradual increase of sp2-hybridised carbon content 6 in the sp3-hybridised layer matrix in the vicinity of the surface of a substrate 4, as shown in Figure 3. The right-hand side of Figure 3 shows the evolution 5 of sp2 content at the grain boundaries of the UNCD (Ultra Nano Crystalline Diamond) coating 3.

The following methods have been demonstrated leading to such a gradual sp2 enrichment (without being limited to these methods):
- Controlled increase of methane or carbon containing gas concentration or adding an additional carbon containing gas at the end of the growth process: during the last period of CVD diamond growth a gradually controlled increase of the carbon containing reactant gas (e.g. methane) or adding an additional carbon containing gas (e.g. acetylene) changes the ratio of sp2/sp3 within the diamond structure or diamond bulk material respectively leading to e.g. the highest amount at the surface or other local distribution-functions.

- Deposition parameter variation: the deposition of nanocrystalline diamond according to the process referenced above (AT399726B) having the highest sp3 content of more than 97% (detection limit) is performed at an optimal parameter set comprising pressure in the vacuum system, temperature of the filaments, temperature of the substrate, gas flow of carbon containing gas, gas flow of hydrogen and distance between filaments and substrate. Due to increase or reduction of substrate temperature and/or pressure the sp2/sp3 ratio can be influenced additionally. This variation should be realised at the end of the growth process to achieve the gradual sp2-enrichment close to the surface.
- Nitrogen adding: during the growth of diamond, a certain quantity of gaseous nitrogen is introduced into the reaction chamber. The process of secondary nucleation (growth of new diamond grains, instead of growing those already formed) is enhanced and this leads to a decreasing of the grain size, down to only a few nanometres. The smaller grains allow a lower roughness of the coating and moreover enhance the amount of sp2-hybridized carbon. Another process, enlarging the sp2 content in the diamond as well, is the inclusion of sp2 grains in the sp3 diamond matrix.
- Argon adding: during the growth of diamond, the increase of methane concentration to a very high level and/or replacing up to 100 % of hydrogen by argon or other elements such as nitrogen can also lead to the same effects.
- Adding other elements: other gases of any kind may be used, such as the rare gases neon, helium, krypton or xenon, without being restricted to them.

The solution of the described dust-problem due to electrostatic charging effect can be achieved by increasing the electrical conductivity of the diamond films thereby decreasing the resulting resistivity of the nanocrystalline diamond film down to a few Ohm.cm, and preferentially down to 10-2 Ohm.cm.

A sufficient conductivity of the diamond layer and the change of its surface polarity (hydrophilic/hydrophobic) can be achieved using the following methods or processes:
- Boron doping (p-type): This process is achieved most preferably during the growth of diamond using a solid, liquid or gaseous source of boron. The substitution of a part (up to 0,1 %) of the carbon atoms from diamond by boron atoms leads to the generation of holes (lack of electrons). The ionisation energy of boron is 0,37 eV and thus very low. This allows the generation of a sufficient quantity of the free charge carriers even at room temperature. The availability of free charge carriers (in this case holes) increases the electrical conductivity of the diamond film. The electrostatic charges are thus evacuated to the bulk of the diamond film. The attraction of dust is therefore considerably reduced or totally eliminated. The higher the boron concentration in the reaction chamber, the higher is the conductivity, in the range of 1016 - 1021 cm-3. The resistivity can decrease down to 10-2 Ohm.cm.

The invention can be used in micromechanical watch movements, in particular for the realisation of escapement wheels and pallets and other friction-relevant systems.

The above detailed description with reference to the drawings illustrates rather than limits the invention. There are numerous alternatives, which fall within the scope of the appended claims. For instance, the invention can also be used to enhance tribological performances in others macroscopic or microscopic mechanisms where at least one part/piece can be coated with diamond. Application examples are Micro-Electro-Mechanical Systems (MEMS), Nano-Electro-Mechanical Systems (NEMS), Electrical motors, in particular micro-motors, pumps, in particular micro-pumps, vacuum systems, static and/or kinetic systems such as engines, etc., without departing from the invention.

The word "comprising" does not exclude the presence of other elements or steps than those listed in a claim. The word "a" or "an" preceding an element or step does not exclude the presence of a plurality of such elements or steps. The mere fact that respective dependent claims define respective additional features, does not exclude a combination of additional features, which corresponds to a combination of dependent claims.

## Claims

1. Method for coating micromechanical components of a micromechanical system, in particular a watch movement, comprising:
• providing a substrate (4) component to be coated;
• providing said component with a first diamond coating (2) doped such as to increase the conductivity of the diamond layer;
• providing said component with a second diamond coating (3); wherein :
• said second diamond coating (3) is provided by deposition in a reaction chamber;
during deposition of said second coating (3), a controlled increase of the carbon content within the reaction chamber is provided, thereby providing an increase of the sp2/sp3 carbon (6) bonds in the substantially outer portion of the coating up to an sp2 content substantially between 1% and 75%.

2. Method for coating micromechanical components of a micromechanical system according to claim 1, wherein said sp2 content is substantially between 1% and 45%, and most preferably between 15% and 30%.

3. Method for coating micromechanical components of a micromechanical system according to claim 1 or 2, wherein the first diamond coating is doped with boron, or phosphorus or sulphur or aluminum.

4. Method for coating micromechanical components of a micromechanical system according to any one of claims 1 to 3, wherein the first and second diamond coatings are provided by CVD in a reaction chamber.

5. Method for coating micromechanical components of a micromechanical system according to any one of claims 1 to 4, wherein the thickness of the first layer is between 500 nm and 100 micrometers, and most preferably less than 10 micrometesr.

6. Method for coating micromechanical components of a micromechanical system according to any one of claims 1 to 5, wherein the thickness of the second layer is between 1 and 100 micrometers, and most preferentially less than 10 micrometers.

7. Method for coating micromechanical components of a micromechanical system according to any one of preceding claims, wherein the micromechanical component is an escapement wheel and wherein during process, the escapement wheel is mounted on a refractory wire, so that the rotation axis of the escapement wheel is substantially horizontal.

8. Method for coating micromechanical components of a micromechanical system according to any one of preceding claims, wherein said increase of carbon content is obtained by increasing the proportion of carbon containing reactant gas.

9. Method for coating micromechanical components of a micromechanical system according to any one of preceding claims, wherein said increase of carbon content is obtained by adding an additional carbon containing gas.

10. Method for coating micromechanical components of a micromechanical system according to any one of preceding claims, wherein said increase of carbon content is obtained by increasing the temperature and/or pressure within the processing reaction chamber.

11. Method for coating micromechanical components of a micromechanical system according to any one of preceding claims, wherein said increase of carbon content is obtained by adding gaseous nitrogen to the reaction chamber.

12. Method for coating micromechanical components of a micromechanical system according to any one of preceding claims, wherein said increase of carbon content is obtained by replacing hydrogen by argon.

13. Method for coating micromechanical components of a micromechanical system according to any one of preceding claims, wherein said increase of carbon content is obtained by adding at least one rare gas.

14. Micromechanical component for a micromechanical system, in particular a watch movement, wherein said component is obtained with a method according to any one of claims 1 to 13.

15. Micromechanical component according to claim 14, wherein the component is an escapement wheel or a pallet.
